# EUROPÄISCHE PATENTSCHRIFT

(11) **EP 1 484 433 B1**
(45) Veröffentlichungstag und Bekanntmachung des Hinweises auf die Patenterteilung: **24.05.2006**
(21) Anmeldenummer: 03012980.3
(22) Anmeldetag: 07.06.2003
(51) Int. Cl.: C23C 28/02, C25D 5/56, C23C 14/58, C23C 14/20

(54) **Zinkbeschichtung von elektrisch nicht leitenden Oberflächen**
Zinc coating of electrically non conducting surfaces
Revêtement en zinc de surfaces électriquement non conductrices

(43) Veröffentlichungstag der Anmeldung: 08.12.2004
(73) Patentinhaber: Galvano Röhrig GmbH, 42655 Solingen (DE)
(72) Erfinder: Röhrig, Christian, 42719 Solingen (DE); Ribbe, Thomas, 40764 Langenfeld (DE)
(74) Vertreter: Sternagel, Fleischer, Godemeyer & Partner

(56) Entgegenhaltungen:
- EP-A- 0 533 575
- EP-A- 0 679 706
- WO-A-03/004261
- GB-A- 1 329 506
- LAUBER F: "METALLBESCHICHTUNG VON KUNSTSTOFFGEHAUSEN" ELEKTRONIK, FRANZIS VERLAG GMBH. MUNCHEN, DE, Bd. 38, Nr. 13, 23. Juni 1989 (1989-06-23), Seiten 127-129, XP000066414 ISSN: 0013-5658

## Beschreibung

Die Erfindung betrifft einen Gegenstand, der zumindest zum Teil eine Oberfläche aus einem nicht leitenden Material aufweist, auf die eine elektrisch leitende Beschichtung aufgebracht ist und ein Verfahren zur Beschichtung von elektrisch nicht leitenden Materialien.

Kunststoffe werden aufgrund ihres geringen Gewichts, ihres vergleichsweise geringen Preises und ihrer guten Formgebungseigenschaften bevorzugt, als Grundwerkstoff für technische und dekorative Anwendungen eingesetzt. Für technisch anspruchsvolle Einsatzgebiete werden in vielen Fällen die Eigenschaften der eingesetzten Polymerwerkstoffe durch Füllstoffe wie Glas- oder Kohlefasern modifiziert. Eine weitere Funktionalisierung durch metallische oder keramische Schichten erfolgt spezifisch abgestimmt auf die Anforderungen um das jeweilige Bauteil. So werden beispielsweise beim Einsatz in der Elektronik Bauteile gefordert, die entweder auf der gesamten Oberfläche oder partiell leitfähig sind. Zusätzliche Anforderungen an die Schicht sind verbesserte mechanische und chemische Beständigkeit, z.B. als Verschleiß- und Korrosionsschutz bei mechanotronischen Anwendungen, sowie dekorative Eigenschaften.

Im Stand der Technik erfolgt die Beschichtung von Kunststoffen grundsätzlich mittels außenstromlosen (CD, chemical deposition) oder mittels vakuumgestützten Verfahren (PVD, physical vapour deposition). Spezielle Verfahren sehen auch die Direktgalvanisierung von Kunststoffen vor. Als erster Schritt wird in der Regel eine Haft- und/oder Leitschicht aufgebracht. Sobald die Oberfläche elektrisch leitfähig ist, können weitere Schichten auch galvanisch (ECD-Verfahren, elektrochemical deposition) aufgebracht werden. Insbesondere durch die Kombination von plasma- und nasschemischen Verfahren kann ein breites Spektrum an Oberflächeneigenschaften realisiert werden. Ein typisches Beispiel hierfür ist das mittels PVD-Verfahren abgeschiedene Schichtsystem Chrom/Kupfer. Hier wird dünn abgeschiedenes Chrom zur Haftvermittlung eingesetzt und Kupfer als Leitschicht aufgebracht. Die so erzeugte Oberfläche kann sowohl zum Shielding eingesetzt werden, als auch als Basis für eine anschließende dekorative oder funktionelle galvanische Beschichtung dienen. Die Funktionalität des so erzeugten Werkstoffverbundes hängt wesentlich von der Haftfestigkeit der aufgebrachten Schichten ab. Dies wird insbesondere bei füllstoffhaltigen Polymeren nur durch sorgfältige Abstimmung der gesamten Prozesskette erreicht.

Die Nachfrage nach galvanisierten Kunststoffen wächst ständig. Das ist auf eine Reihe von Vorteilen gegenüber den herkömmlichen galvanisierten metallischen Gegenständen zurückzuführen. Eine entscheidende Rolle spielen das geringe Gewicht, die unkomlizierte Verarbeitbarkeit und vielfältige Gestaltungsmöglichkeiten, welche besonders für die Automobilindustrie von Bedeutung sind. Die niedrigen Produktionskosten für die Herstellung von Kunststoffteilen (z.B. Spritzgußverfahren) sind ein weiterer wichtiger Faktor.

Für die Metallisierung ist bisher nur eine begrenzte Anzahl von Kunststoffen wie zum Beispiel ABS, ABS-PC, Polysulfon, Polyamid, Polyetherimid, Polyarylamid, Polyethertherephthalat, geeignet.

Grundvoraussetzung für jede Kunststoffgalvanisierung ist, dass auf den nicht leitenden Kunststoff eine leitende Schicht festhaftend aufgebracht wird, welche die Basis für die sich anschließende Metallisierung ist. Die wesentlichen Arbeitsgänge sind die Konditionierung der Kunststoffoberfläche, das Bekeimen und schließlich die chemisch-reduktive Metallabscheidung oder Direktmetallisierung.

Das Konditionieren ist eine spezielle Behandlung der Oberfläche zur Erzeugung einer bestimmten Oberflächenladung bzw. Herstellung geeigneter Mikrokavemen, welche die Aufnahme von Metallkeimen ermöglicht. Die Bekeimung kann auf dem Wege der kolloidalen oder ionogenen Katalyse erfolgen. Der klassische kolloidale Prozeß, der vor der eigentlichen Metallisierung erforderlich ist, umfaßt nach dem Beizen (zum Beispiel mit CrO₃/H₂SO₄, reiner CrO₃) eine Vielzahl von Reduktions- und Spülvorgängen. Das Verfahren der ionogenen Katalyse bietet eine vereinfachte Variante, wobei sich an den Beizvorgang und das Spülen unmittelbar die Aktivierung mit Palladiumionen anschließt. Die Reduktion des Aktivators erfolgt mit NaH₂PO₂. Anschließend erfolgt die chemische Vernickelung.

In der Automobilindustrie wird für die Galvanisierung von Außenteilen vorwiegend der folgende Schichtaufbau genutzt: Vornickel - Glanzkupfer - Halbglanznickel - Glanznickel - Rissnickel - Chrom.

Die DE 196 11 137 beschreibt ein Verfahren zur galvanotechnischen Direktmetallisierung einer Kunststoffoberfläche, wobei die zu metallisierende Kunststoffoberfläche nach einer Vorreinigung mit Chromschwefelsäure oder alkalischer Permanganatlösung angeätzt und danach einer Reinigungsspülung in einem Behandlungsbad unterworfen wird. Im Anschluß daran wird die Kunststoffoberfläche mit Salzsäure vorbehandelt. Danach wird die Kunststoffoberfläche mittels eines Palladium/Zinn-Aktivators mit einer Palladium/Zinn-Beschichtung versehen. Anschließend wird die Oberfläche mit einer Lösung behandelt, die an einen Komplexbildner gebundene Kupferionen enthält. Dabei wird das Zinn aus der Palladium/Zinn-Beschichtung gegen Kupfer ausgetauscht. Die so vorbehandelte Kunststoffoberfläche wird anschließend in einem Elektrolyten, vorzugsweise einem Glanzkupferelektrolyten, der direkten galvanischen Metallisierung unterworfen.

Die EP 0 997 061 beschreibt ein Verfahren zum Metallisieren eines elektrisch nicht leitende Oberflächenbereiche aufweisenden Substrats mit den Verfahrensschritten: Behandeln des Substrats mit einer Lösung, enthaltend ein Palladiumkolloid; Behandeln mit einer Ätzlösung; Erzeugen einer ersten Metallschicht auf den nicht leitenden Oberflächenbereichen durch stromlose Metallabscheidung, wobei als erste Metallschicht eine Nickel-, Kobalt-, Kupfer- oder Palladiumschicht oder eine Schicht einer Legierung dieser Metalle abgeschieden wird; und Erzeugen einer zweiten Metallschicht auf der ersten Metallschicht durch elektrolytische Metallabscheidung, wobei als erste Metallschicht eine Nickelschicht oder eine Nickellegierungsschicht abgeschieden wird.

Die Automobilindustrie fordert seit geraumer Zeit die Beschichtung von Kunststoffen, die deutlich bessere mechanische Eigenschaften haben als die zur Zeit galvanisierbaren. Die konventionelle Kunststoffgalvanik hat Grenzen hinsichtlich der beschichtbaren Materialien. Zwar sind ABS-Kunststoffe problemlos beschichtbar, die mechanische Belastbarkeit ist jedoch eingeschränkt. Aus diesem Grunde werden Mischungen aus ABS und Polykarbonaten eingesetzt, wobei jedoch für eine einwandfreie Galvanisierung der PC-Anteil auf ca. 25 % begrenzt ist. Die galvanische Beschichtung von Polyamiden ist bis heute noch nicht verfahrenssicher gelungen. Nachteilig bei den Verfahren des Standes der Technik ist auch, dass die Prozeßfolge der konventionellen Kunststoffgalvanik sehr aufwendig ist und mit hohen Kosten verbunden ist. Weiterhin nachteilig ist die Umweltbelastung durch die bei der konventionellen Kunststoffgalvanik verwendeten Lösungen, beispielsweise für das Beizen (Chromschwefelsäure, Phosphorsäure, Kaliumpermanganatlösungen), die reduktiv arbeitenden Elektrolyte (chemisch Nickel und Kupfer), sowie die hohe Belastung an Chrom-VI, Komplexbildner, Reduktions- und Oxidationsmittel). Die Verwendung dieser Lösungen stellt deutlich erhöhte Anforderungen an die Arbeitsplatzumgebung und außerdem sind ihre Standzeiten begrenzt, z.B. durch den Eintrag von gelösten Kunststoffen und sind außerdem schwierig zu entsorgen. Zudem sind die verwendeten Palladiumaktivatoren sehr teuer und die Verfügbarkeit von Palladium wird in Zukunft begrenzt sein.

Die technische Aufgabe war es daher ein Verfahren bereitzustellen, mit dem elektrisch nicht leitende Materialien mit einer elektrisch leitenden Beschichtung versehen werden können, und wobei die Auswahl an elektrisch nicht leitenden Materialien, die für eine Beschichtung verwendet werden können, sehr stark erweitert wird. Weiterhin war es die technische Aufgabe, neue Produkte bereitzustellen, die zumindest zum Teil eine Oberfläche aus einem elektrisch nicht leitenden Material aufweisen, auf die eine elektrisch leitende Beschichtung aufgebracht ist.

Haftfeste Metallisierungen beispielsweise von Kunststoffen kann über eine PVD-Beschichtung erfolgen. Ein typisches Beispiel hierfür ist das mittels PVD-Verfahren abgeschiedene Schichtsystem Chrom/Kupfer. Hierbei wird dünn abgeschiedenes Chrom zur Haftvermittlung eingesetzt und Kupfer als Leitschicht aufgebracht. Nachteilig bei dem genannten PVD-Schichtsystem ist, dass die aufgebrachte Kupferschicht aufgrund der schlechten Kupferbedeckung in tiefliegenden Bereichen, aufgrund von Graten am Kunststoffgrundmaterial, aufgrund von Pin-Holes aus der PVD-Beschichtung die aufgebrachte Kupferschicht nie vollständig geschlossen ist. Aufgrund des niedrigen Redoxpotentials des Chroms ist das direkte Aufbringen von sauer Kupfer schwer durchführbar. Die große Potentialdifferenz Cr/Cu von cirka 1 V führt zu Korrosion an der Grenzfläche PVD Cr/PVD Cu und damit zur Ablösung der PVD Cu-Schicht. Diese Ablösung kann sich über den Beschichtungsprozeß auf das komplette Bauteil auswirken und führt damit zum Kompletausfall.

Eine direkte Beschichtung mit sauer Kupfer ist nur möglich, wenn im sauren Kupferelektrolyten sofort eine vollständige Bedeckung des Bauteils stattfindet bzw. die saure Kupferschicht mit Druckspannung abgeschieden wird und dick genug ist, um Haftungsprobleme zu kaschieren. Dies erfordert allerdings, dass der saure Kupferelektrolyt in sehr engen Verfahrensbedingungen geführt wird, was in der Praxis nicht realisierbar ist.

Eine chemische Vormetallisierung mittels chemisch Kupfer und Nikkel scheidet ebenfalls aus und führt nicht zu den gewünschten Ergebnissen, da die PVD Cr-Schicht als zusätzliches Reduktionsmittel für die Metallabscheidung wirkt.

Eine weitere technische Aufgabe war es daher, haftfeste elektrisch leitende Beschichtungen von PVD-beschichteten elektrisch nicht leitenden Materialien bzw. neue Produkte bereitzustellen, die zumindest zum Teil eine Oberfläche aus einem elektrisch nicht leitenden Material aufweisen, auf die eine elektrisch leitende Beschichtung aufgebracht ist.

Die technische Aufgabe wird gelöst durch einen Gegenstand, der zumindest zum Teil eine Oberfläche aus einem elektrisch nicht leitenden Material aufweist, auf die eine elektrisch leitende Beschichtung aufgebracht ist, wobei die elektrisch leitende Beschichtung mindestens eine Schicht aufweist, die Zink enthält.

Weiterhin wird die technische Aufgabe gelöst durch ein Verfahren zur Beschichtung von elektrisch nicht leitenden Materialien, wobei auf das elektrisch nicht leitende Material eine elektrisch leitende Schicht enthaltend Zink aufgebracht wird. Bevorzugt wird das elektrisch nicht leitende Material zunächst mit einem PVD-Verfahren mit einer Chrom-, und einer Kupferschicht versehen, und darauf eine Zink enthaltende Schicht durch Galvanisieren aufgebracht.

In weiteren bevorzugten Ausführungsformen ist das elektrisch nicht leitende Material ein Kunststoffmaterial. Andere elektrisch nicht leitende Materialien schließen beispielsweise Keramik ein. Aufgrund des erfindungsgemäßen Verfahrens können nun z.B. alle Arten von Kunststoffen, die die gewünschten mechanischen Merkmale aufweisen, beschichtet werden, wobei auch die Gestaltungsmöglichkeiten der Bauteile größer werden. So können beispielsweise alle Arten von Kunststoffen wie z.B. ABS, unverstärkte Polyamide, Polyamide enthaltend bis zu 40 % Glasfaser, mineralverstärkte Polyamide, transparente Polyamide, Polyurethan, lackiertes ABS, Polyethylen, Polypropylen, Polyvinylchlorid und Kunststoffteile aus deren Mischungen, aber auch andere Gegenstände wie lackierte Zinkdruckgussteile beschichtet werden.

Das erfindungsgemäße Verfahren zeichnet sich durch eine kürzere Prozessfolge aus und ist deutlich preiswerter als die Verfahren des Standes der Technik. Das erfindungsgemäße Verfahren schont weiterhin die Resourcen und ist weiterhin bedeutend umweltfreundlicher, weil auf kritische Chemiekalien wie Chromschwefelsäure, Phosphorsäure, Kaliumpermanganatlösungen, Formaldehyd und andere Lösungen verzichtet werden kann. Weiterhin ist das erfindungsgemäße Verfahren deutlich preiswerter als konventionelle Kunststoffbeschichtungen, da ebenfalls auf das teure Palladium verzichtet wird.

Mit dem neuen erfindungsgemäßen Verfahren sind völlig neue Produkte herstellbar, wie beispielsweise KFZ-Scheinwerfer aus einem transparenten Kunststoff mit einer PVD-Chromschicht als Reflektionsschicht und einem galvanischen Aufbau zum Schutz der Reflektionsschicht vor Korrosion und mechanischen Beschädigungen.

In einer bevorzugten Ausführungsform liegt das Zink in der Zink enthaltenden Schicht in Form von elementarem Zink vor.

Besonders bevorzugt ist die auf dem elektrisch nicht leitenden Material aufgebrachte PVD-Schicht eine Schicht aus reinem elementaren Chrom.

In einer weiteren bevorzugten Ausführungsform ist auf der PVD-Schicht enthaltend Chrom eine weitere PVD-Schicht aus reinem elementarem Kupfer aufgebracht.

Die Schicht enthaltend Zink ist eine galvanisch aufgebrachte Schicht. In weiteren besonders bevorzugten Ausführungsformen umfasst die Schicht enthaltend Zink weitere elementare Metalle oder Metallverbindungen, wobei vorzugsweise die Schicht enthaltend Zink mit anderen Metallen und Dispersate legiert oder gemischt ist.

Dabei sind die weiteren Metalle oder Metallverbindungen, die in der Schicht enthaltend Zink, enthalten sind, vorzugsweise ausgewählt aus der Gruppe Eisen, Gold, Kobalt, Kupfer, Mangan, Nickel, Siliciumcarbid, Borcarbid, Aluminiumoxid oder Mischungen derselben.

In einer weiteren besonders bevorzugten Ausführungsform sind auf der Schicht enthaltend Zink weitere Schichten enthaltend elementares Metall oder Metallverbindungen aufgebracht.

In einer weiteren besonders bevorzugten Ausführungsform weist der Gegenstand zumindest an den Stellen des elektrisch nicht leitenden Materials folgende Schichtenfolge auf:
a) elektrisch nicht leitendes Material, vorzugsweise Kunststoffmaterial;
b) PVD-Schicht enthaltend Chrom;
c) PVD-Schicht enthaltend Kupfer;
d) Schicht enthaltend Zink, und
e) optional weitere metallhaltige Schichten.

Das erfindungsgemäße Verfahren wird vorzugsweise unter Verwendung eines Kunststoffmaterials als elektrisch nicht leitendes Material als Substrat zur Beschichtung verwendet. Durch das erfindungsgemäße Beschichtungsverfahren wird die Auswahl an Substraten zur Beschichtung deutlich erhöht. Als elektrisch nicht leitende Materialien können Kunststoffe aber auch Keramik und andere Materialien beschichtet werden. Mit dem erfindungsgemäßen Verfahren können beispielsweise ABS, unverstärkte Polyamide, Polyamide enthaltend bis zu 40 % Glasfaser, mineralverstärkte Polyamide, transparente Polyamide, Polyurethan, lackiertes ABS, Polyethylen, Polypropylen, Polyvinylchlorid und Kunststoffteile aus deren Mischungen, sowie z.B. lackierte Zinkdruckgussteile beschichtet werden.

In einem bevorzugten Verfahren wird das Zink in der Zink enthaltenden Schicht in Form von elementarem Zink aufgebracht. Vorzugsweise wird dabei auf das elektrisch nicht leitende Material eine Schicht enthaltend Chrom vorzugsweise eine Schicht aus reinem elementaren Chrom mit einem PVD-Verfahren aufgebracht.

In einem weiteren besonders bevorzugtem Verfahren wird auf die PVD-Schicht enthaltend Chrom eine weitere PVD-Schicht aus reinem elementaren Kupfer aufgebracht.

Dabei dient die PVD-Chromschicht als Schicht zur Haftvermittlung und die PVD-Kupferschicht dient hierbei als elektrisch leitfähige Schicht zur weiteren Beschichtung. Im Verfahren wird die Schicht enthaltend Zink galvanisch aufgebracht. Besonders bevorzugt wird die Schicht enthaltend Zink als Mischung oder Legierung mit anderen Metallen aufgebracht, wobei besonders bevorzugt die Schicht enthaltend Zink mit anderen Metallen und Dispersate legiert oder gemischt ist. Bei den weiteren Metallen oder Metallverbindungen handelt es sich vorzugsweise um solche ausgewählt aus der Gruppe Eisen, Gold, Kobalt, Kupfer, Mangan, Nickel, Borcarbid, Aluminiumoxid, Siliciumcarbid oder Mischungen derselben.

In weiteren besonders bevorzugten Verfahren werden auf die Schicht enthaltend Zink weitere Schichten enthaltend Metall, besonders bevorzugt durch Galvanisieren aufgebracht.

Ein besonders bevorzugtes Verfahren weist die folgenden Schritte auf:
a) Aufbringen einer PVD-Schicht enthaltend Chrom auf ein elektrisch nicht leitendes Material, vorzugsweise auf ein Kunststoffmaterial:
b) Aufbringen einer PVD-Schicht enthaltend Kupfer auf die PVD-Schicht enthaltend Chrom;
c) Aufbringen einer Schicht enthaltend Zink auf die PVD-Schicht enthaltend Kupfer, vorzugsweise durch Galvanisieren, und
d) optional Aufbringen weiterer metallhaltiger Schichten auf die Schicht enthaltend Zink, vorzugsweise durch Galvanisieren.

Mit dem erfindungsgemäßen Verfahren wurde ein galvanisches Schichtsystem gefunden, das die elektrochemische Korrosion der PVD-Schicht verhindert. Mit dem erfindungsgemäßen Verfahren ist es möglich, Zink als galvanisch abscheidbares Metall mit einem Standardpotential von E₀Zn = -0,76 V auf eine PVD-Schicht aufzubringen, die wiederum auf eine Oberfläche aus einem elektrisch nicht leitenden Material aufgebracht ist. Die Zinkschicht kann mit anderen Metallen oder Dispersate legiert oder gemischt sein. Als Beispiele für diese Beimischungen sind Mangan, Eisen, Kobald, Nickel, Kupfer und Siliciumcarbid, Borcabid, Aluminiumoxid oder Mischungen derselben zu nennen. Die Metallbeimischungen betragen vorzugsweise 0,3 bis 15 g/l im Zinkelektrolyten. Das Zink der ersten galvanischen Metallschicht schützt die PVD-Schicht in den nachfolgenden Prozessen als sogenannte Opferanode, da die Potentiale der nachfolgenden Prozesse meist höher liegen. Als Mindestschichtdicke dieser zinkenthaltenden Schicht ist eine Bedeckung (mit einer Dicke von ca. 0,5 - 80 µm) ausreichend.

In dem erfindungsgemäßen Verfahren kann die Schicht enthaltend Zink aus allen nicht alkalischen Lösungen abgeschieden werden. So können beispielsweise schwefelsaure und andere schwach saure und neutrale Elektrolyten mit einem pH-Wert von bis zu 7,5 aber auch sulfamathaltige und pyrophosphathaltige Elektrolyte zur Abscheidung der Zink enthaltenden Schicht verwendet werden. Weiterhin können die Elektrolyte ammoniumhaltig oder ammoniumfrei betrieben werden. Die Elektrolyte können die üblichen Kornverfeinerer, Glanzzusätze und Netzmittel enthalten. Zudem können die Elektrolyte Komplexbildner enthalten, wie beispielsweise Kaliumnatriumtartrat, Natriumglukonat, Sorbit und andere Zukker und mehrwertige Alkohole. Mit dem erfindungsgemäßen Verfahren können die Bauteile unmittelbar nach der PVD-Beschichtung verzinkt werden oder auch in einer geeigneten benetzenden Lösung, vorzugsweise mit einem pH kleiner gleich 7 vorbehandelt werden. Nach dem Verzinken können die Bauteile mit einer für das beschichtete Substrat üblichen Temperatur getempert werden.

In den nachfolgenden Bespielen wird das erfindungsgemäße Verfahren näher erläutert. Die darin beschriebenen Verfahrensparameter schränken den Gegenstand der vorliegenden Erfindung jedoch nicht ein.

### Beispiele

### 1. Allgemeines Prinzip des erfindungsgemäßen Verfahren

Ein Kunststoffformteil z.B. lackiertes ABS (Styrol-Acrylnitril-Copolymer) oder aus Polyurethan mit einer Fläche von 7 dm² wird zunächst mit einer Chromschicht unter Verwendung eines PVD (Plasma-Vakuum-Deposition) Verfahren beschichtet. Danach erfolgt eine Beschichtung mit einer 1 bis 3 µm starken Kupferschicht, die ebenfalls mit einem PVD-Verfahren aufgebracht wird.

Bei dem PVD-Verfahren wird das Beschichtungsmaterial durch rein physikalische Methoden in die Gasphase überführt und dann auf dem Substrat abgeschieden. Im wesentlichen werden drei verschiedene Verfahrenstechniken unterschieden. Beim Aufdampfen wird das Beschichtungsmaterial im Hochvakuum bis zum Übergang vom festen über den flüssigen in den gasförmigen Zustand erhitzt. Je nach Material kann auch der direkte Übergang von fester zur gasförmigen Phase auftreten. Die notwendige Erwärmung wird über elektrische Widerstandsheizungen durch hochenergetische Elektronen oder durch Laserbeschuss zugeführt. Daneben kann durch das Verfahren des Bogenverdampfens, bei dem durch Zünden eines Lichtbogens zwischen zwei Elektroden das Elektrodenmaterial verdampft wird, zur Anwendung kommen. Beim Zerstäuben kommt es durch Beschuss eines Targets, das aus dem gewünschtem Beschichtungsmaterial besteht, mit energiereichen Edelgasionen zur Zerstäubung der Oberfläche. Als lonenquelle dient meist ein Edelgasplasma. Die Oberfläche des Targetmaterials kann auch mit Ionenstrahlen abgetragen werden. Diese Technik erlaubt sehr genauen Abtrag - und entsprechend genaue Aufwachsraten auf dem Substrat.

Nach dem Auftragen der Chrom- und der anschließenden Kupferschicht werden die Teile galvanisch verzinkt. Im Gegensatz zu den Verfahren des Standes der Technik können die Teile ohne weitere Vorbehandlung in den Zinkelektrolyten eingetaucht werden. In Tabelle 1a werden die Verfahrensschritte beginnend mit dem Verzinken der PVD-Schichten und weiteren Galvanisierungsschritten zusammengefasst. Die verwendeten Lösungen werden in Tabelle 2 dargestellt. Die Tabelle 3 zeigt weitere Beispiele für die Galvanisierung mit verschiedenen Zinkelektrolyten.

Die zu beschichtenden Teile werden für 10 min in den Zinkelektrolyten bei einer Temperatur von ca. 30 °C und einer Stromdichte von 1 bis 2 A/dm² eingetaucht und verzinkt. Anschließend werden die Teile mit Wasser gespült und durch Eintauchen in eine 3%ige Säurelösung aktiviert. Die hierbei verwendeten Lösungen werden ebenfalls in Tabelle 2 beschrieben. Nach dem Aktivieren mit der Säure wird erneut mit Wasser gespült. Anschließend erfolgt eine anodische Entfettung bei einer Stromdichte von 2 A/dm² für 0,5 min Anschließend wird mit Wasser gespült und die Teile werden mit einer verdünnten Mineralsäure oder deren Salze aktiviert. Danach wird wieder mit Wasser gespült. Anschließend werden die Teile in einen zyanidischen Kupferelektrolyten getaucht und bei einer Stromdichte von 0,8 bis 1 A/dm² bei ca. 60 °C mit Kupfer galvanisch beschichtet. Anschließend erfolgt eine weitere Spülung mit Wasser und eine Aktivierung mit einer verdünnten Mineralsäure oder deren Salze, gefolgt von Spülen mit Wasser. Danach erfolgt beispielsweise eine Galvanisierung in einem Glanzkupferelektrolyten für 60 min bei einer Stromdichte von 3 A/dm² bei Raumtemperatur. Anschließend wird erneut mit Wasser gespült. Die Bauteile können auch mit einer Zinkschicht versehen werden, mit einer Dicke, die eine anschließende mechanische Bearbeitung zulässt.

Danach kann entweder der gewünschte Schichtaufbau, z.B. Glanznickel/Chrom oder Doppelnickel/Chrom direkt aufgebracht werden oder zuvor eine mechanische Behandlung z.B. Polieren erfolgen. Die Verfahrensschritte werden in Tabelle 1b (Aufbringen von Glanzchrom) dargestellt.

Zum Aufbringen von Glanzchrom werden die Teile zunächst in verdünnte Mineralsäure oder deren Salze aktiviert, anschließend in Wasser gespült und danach in einen Nickelelektrolyten getaucht und bei einer Stromdichte von 3 bis 4 A/dm² bei einer Temperatur von 65 °C für 30 min vernickelt. Anschließend wird mit Wasser gespült und durch Eintauchen in Chromsäure aktiviert. Es schließt sich ein Schritt zur Verchromung durch Eintauchen in einem Chromelektrolyten für 5 min bei einer Stromsdichte von 10 bis 12 A/dm² bei einer Temperatur von ca. 39 °C an. Anschließend wird mit Wasser gespült und schließlich getrocknet.

Als Alternative zum Glanzchrom können auch andere Oberflächen aufgebracht werden z.B. Glanzgold, dekoratives Mattnickel, u.s.w.. Weiterhin können beispielsweise andere Verchromungsarten gewählt werden, wie z.B. mikrorissiges Chrom, mikroporiges Chrom, Farb- und Schwarzchrom.

In der nachfolgenden Tabelle 1a wird die zuvor beschriebene Bearbeitungsfolge beginnend mit dem Schritt des Verzinkens der PVD-beschichteten Kunststoffteile zusammengefaßt.

**Tabelle 1a typische Bearbeitungsfolge:**

| **Medium** | **Ziel der Exposition** | **Strom** | **Temperatur** |
|---|---|---|---|
| Zusammensetzung: | **(ggf. Zeit in Minuten)** | | |
| Tabelle 2 | | | |
| | | | |
| Zinkelektrolyt | 10 | 1 - 2 A/dm² | ca. 30 °C |
| Wasser | Spülen | | |
| Wasser | Spülen | | |
| Wasser | Spülen | | |
| Säure (3%ig) | Aktivieren | | |
| Wasser | Spülen | | |
| Wasser | Spülen | | |
| Entfettung (anodisch) | 0,5 | 2 A/dm² | |
| Wasser | Spülen | | |
| Wasser | Spülen | | |
| verdünnte Mineralsäuren und deren Salze | Aktivieren | | |
| Wasser | pülen | | |
| Wasser | Spülen | | |
| Kupferelektrolyt (zyan.) | 15 - 20 | 0,8 - 1 A/dm² | ca. 60°C |
| Wasser | Spülen | | |
| Wasser | Spülen | | |
| Wasser | Spülen | | |
| verdünnte Mineralsäuren und deren Salze | Aktivieren | | |
| Wasser Spülen | | | |
| Wasser | Spülen | | |
| Kupferelektrolyt (sauer) | 60 | 3 A/dm² | Raumtemp. |
| Wasser | Spülen | | |
| Wasser | Spülen | | |
| Wasser | Spülen | | |

| | | | |
|---|---|---|---|
| Anschließend erfolgt eine mechanische Bearbeitung oder direkte Aufbringung der Erdschicht | | | |

**Tabelle 1b Aufbringung der Endschicht: Aufbringen von Glanzchrom**

| **Medium** | **Ziel der Exposition** | **Strom** | **Temperatur** |
|---|---|---|---|
| | **(ggf. Zeit in Minuten)** | | |
| verdünnte Mineralsäu- ren und deren Salze | Aktivieren | | |
| Wasser | Spülen | | |
| Wasser | Spülen | | |
| Wasser | Spülen | | |
| Nickelelektrolyt | 30 | 3-4 A/dm² | ca. 65 °C |
| Wasser | Spülen | | |
| Wasser | Spülen | | |
| Wasser | Spülen | | |
| Chromsäure | Aktivieren | | |
| Chromelektrolyt | 5 | 10-12A/dm2 | ca. 39 °C |
| Wasser | Spülen | | |
| Wasser | Spülen | | |
| Wasser | Spülen | | |
| Wasser | Spülen (heiß) | | ca. 60°C |
| | Trocknen | | |

**Tabelle 2 Stoffliche Zusammensetzungen der in dem Verfahren nach Tabelle 1 verwendeten Lösungen:**

| Medium | Bestandteile | Menge |
|---|---|---|
| Zinkelektrolyt | Zinkchlorid | 80 g/l |
| | Kaliumchlorid | 180 g/l |
| | Borsäure | 20 g/l |
| | Kornverfeinerer | |
| | Glanzbildner | |
| | Stabilisatoren | |
| | Netzmittel | |
| k) Säure (Aktivieren) hier werden vorzugsweise verdünnte Mineralsäuren und deren Salze eingesetzt, z.B.: | | |
| | Schwefelsäure (rein) | 30 g/l |
| oder | | |
| | Natriumhydrogensulfat | 30 - 40 g/l |
| oder | Natriumhydrogensultat | 35 g/l |
| | Natriumhydrogenfluorid | 5 g/l |
| 1) Entfettung elektrolytisch | Natriumhydroxid | 50 g/l |
| (anodisch/kathodisch) | Soda | 30 g/l |
| | Natriumglykonat | 15 g/l |
| | Dispergatoren | 3 g/l |
| | Stärkezucker | 2 g/l |
| m) Kupferelektrolyt | Kaliumzyanid | 150 g/l |
| (zyanidisch) | Kupfer-1-zyanid | 90 g/l |
| | Kaliumrhodanit | 5 g/l |
| | Grundglänzer | 1 - 2 g/l |
| | Glanzzusatz | 1 - 2 g/l |
| | Netzmittel | 0,5 g/l |
| n) Kupferelektrolyt (sauer) | Kupfersulfat | 180 g/l |
| | Schwefelsäure | 70 g/l |
| | Chlorid | 70 mg/l |
| | Grundglänzer | 4 ml/l |
| | Glanzzusatz | 0,8 - 1 mil/l |
| | Netzmittel | 4 ml/l |
| o) Nickelelektrolyt | Nickelsulfat | 250 g/l |
| | Nickelchlorid | 50 g/l |
| | Borsäure | 40 g/l |
| | Grundglänzer | 2 - 5 g/l |
| | Glanzzusatz | 1 - 2 ml/l |
| | Netzmittel | 2 ml/l |
| Die Nickelelektrolyte können unterschiedliche Zusammensetzungen haben. Sie können hochglänzende, halbglänzende, dekorative matte Oberflächen ausbilden, so dass aufgrund der vielseitigen Möglichkeiten beispielhaft obige verfahrenstechnische Rezeptur genannt ist. | | |
| p) Chromsäure | Chromsäure | 30 g/l |
| (Aktivieren vor der Verchromung) | | |
| oder | Chromsäure | 30 g/l |
| | Kieselfluorwasserstoffsäure | 5g/l |
| q) Chromelektrolyt | Chromtrioxid | 250 - 410 g/l |
| | Katalysator | 1,5-2,2 g/l |
| | Schwefelsäure | 2,5 = 3 g/l |
| | Borsäure | 10-15 g/l |

### 2. Galvanische Verzinkung von Chrom bzw. Chrom/Kupfer PVD-beschichteten Kunststoffteilen

Wie im oben beschriebenen Beispiel wird ein Kunststoffformteil z.B. lackiertes ABS oder aus Polyurethan zunächst mit einer Chromschicht unter Verwendung eines PVD (Plasma-Vakuum-Deposition) Verfahren beschichtet, gefolgt von einer PVD-Beschichtung mit einer 1 bis 3 µm starken Kupferschicht.

Nach dem Auftragen der Chrom- und der anschließenden Kupferschicht werden die Teile galvanisch verzinkt. In Tabelle 3 werden verschiedene Beispiele der Zusammensetzungen der verwendbaren Zinkelektrolyte und die Verfahrensparameter wie Temperatur, Stromdichte und Dauer der Galvanisierung zusammengefasst. Die zu beschichtenden Teile werden in den Zinkelektrolyten eingetaucht und unter den in den Beispielen angegebenen Verfahrensparametern verzinkt. In den folgenden Beispielen kann entweder eine reine Zinkschicht (Beispiele a) bis e) ) oder eine Schicht enthaltend Zink und andere Metalle (Beispiele f: Zink/Kobalt; g: Zink/Eisen; h: Zink/Magnesium; i) Zink/Aluminium) abgeschieden werden. Wie im vorhergehenden Beispiel beschrieben können auf die Verzinkung weitere Schichten galvanisch aufgebracht werden.

**Tabelle 3 Beispiele für die Zusammensetzung weiterer Zinkelektrolyten und der Parameter für die galvanische Verzinkung von Chrom bzw. Chrom/Kupfer PVD-beschichteten Kunststoffteilen:**

| Medium | Bestandteile / Parameter | Wert |
|---|---|---|
| a) Zinkelektrolyt schwach sauer | Zinkchlorid | 70 g/l |
| | Kaliumchlorid | 200 g/l |
| | Borsäure | 25g/l |
| | pH | 4,5 |
| | Temperatur | 30 °C |
| | Stromdichte Zeit | 3 A/dm² 10 min |
| b) Zinkelektrolyte schwach sauer | Zinkchlorid | 35 g/l |
| | Kaliumchlorid | 100 g/l |
| | Borsäure | 10g/l |
| | pH | 6,5 |
| | Temperatur | 50 °C |
| | Stromdichte | 1 A/dm² |
| | Zeit | 20 min |
| c) Zinkelektrolyt aus a) | + Ammoniumchlorid | 20g/l |
| | Zeit Zeit | 3 min min |
| d) Zinkelektrolyt aus a) | + Kornverfeinerer | 20 ml/l |
| | + Glanzzusatz | 1 ml/l |
| | Temperatur | 35 °C |
| | Stromdichte | 2 A/dm² |
| | Zeit | 10 min |
| e) Zinkelektrolyt aus b) | + Natriumgluconat | 10 g/l |
| f) Zinkelektrol aus d) | + Kobaltchlorid | 8 g/l |
| g) Zinkelektrolyt aus d) | + Eisenchlorid | 10 g/l |
| | pH | ca. 4 |
| h) saurer Zinkelektrolyt | Zinksulfat | 300 g/l |
| | Natriumsulfat | 70 g/l |
| | Magnesiumsulfat | 60 g/l |
| | pH | 3,0 |
| | Temperatur | 50 °C |
| | Stromdichte | 10 A/dm² |
| | Zeit | 5 min |
| i) Zinksulfatmatelektrolyt | Zinksulfamat | 250 g/l |
| | Aluminiumsulfamat | 35 g/l |
| | Grundglänzer | |
| | Glanzzusatz | |
| | Stabilisatoren | 0,1 g/l |
| | pH | 2,5 |
| | Temperatur | 30°C |
| | Stromdichte | 3 A/dm² |

## Patentansprüche

1. Ein Gegenstand, der zumindest zum Teil eine Oberfläche aus einem elektrisch nicht leitenden Material aufweist, mit einer elektrisch leitenden Beschichtung, **dadurch gekennzeichnet, dass** die elektrisch leitende Beschichtung mindestens eine galvanisch aufgebrachte Zink enthaltende Schicht aufweist, und zwischen dem elektrisch nicht leitenden Material und der Zink enthaltenden Schicht mindestens eine PVD-Schicht enthaltend Chrom und auf dieser mindestens eine PVD-Schicht enthaltend Kupfer angeordnet ist.

2. Der Gegenstand nach Anspruch 1, **dadurch gekennzeichnet, dass** das elektrisch nicht leitende Material ein Kunststoffmaterial ist.

3. Der Gegenstand nach Anspruch 1 oder 2, **dadurch gekennzeichnet, dass** das Zink in der Zink enthaltenden Schicht in Form von elementarem Zink vorliegt.

4. Der Gegenstand nach einem der Ansprüche 1 bis 3, **dadurch gekennzeichnet, dass** die auf dem elektrisch nicht leitenden Material aufgebrachte PVD-Schicht eine Schicht aus reinem elementaren Chrom ist.

5. Der Gegenstand nach einem der Ansprüche 1 bis 4, **dadurch gekennzeichnet, dass** auf der PVD-Schicht enthaltend Chrom eine PVD-Schicht aus reinem elementaren Kupfer aufgebracht ist.

6. Der Gegenstand nach einem der Ansprüche 1 bis 7, **dadurch gekennzeichnet, dass** die Schicht enthaltend Zink weitere elementare Metalle oder Metallverbindungen enthält.

7. Der Gegenstand nach einem der Ansprüche 1 bis 6, **dadurch gekennzeichnet, dass** die Schicht enthaltend Zink mit anderen Metallen und Dispersionen legiert oder gemischt ist.

8. Der Gegenstand nach einem der Ansprüche 1 bis 7, **dadurch gekennzeichnet, dass** die weiteren Metalle oder Metallverbindungen ausgewählt sind aus der Gruppe Chrom, Eisen, Gold, Kobalt, Kupfer, Mangan, Nickel, Siliciumcarbid, Borcarbid, Aluminiumoxid oder Mischungen derselben.

9. Der Gegenstand nach einem der Ansprüche 1 bis 8, **dadurch gekennzeichnet, dass** auf der Schicht enthaltend Zink weitere Schichten enthaltend elementares Metall oder Metallverbindungen aufgebracht sind.

10. Der Gegenstand nach einem der Ansprüche 1 bis 9, **dadurch gekennzeichnet, dass** der Gegenstand zumindest an den Stellen des elektrisch nicht leitenden Materials die Schichtenfolge aufweist:
a) elektrisch nicht leitendes Material, vorzugsweise Kunststoffmaterial,
b) PVD-Schicht enthaltend Chrom,
c) PVD-Schicht enthaltend Kupfer,
d) Schicht enthaltend Zink, und
e) optional weitere metallhaltige Schichten.

11. Ein Verfahren zur Beschichtung von elektrisch nicht leitenden Materialien, wobei auf das elektrisch nicht leitende Material zunächst mindestens eine PVD-Schicht enthaltend Chrom aufgebracht wird, darauf eine PVD-Schicht enthaltend Kupfer aufgebracht wird und auf diese eine elektrisch leitende Zink enthaltende Schicht galvanisch aufgebracht wird.

12. Das Verfahren nach Anspruch 11, **dadurch gekennzeichnet, dass** als elektrisch nicht leitendes Material ein Kunststoffmaterial als Substrat zur Beschichtung verwendet wird.

13. Das Verfahren nach Anspruch 11 oder 12, **dadurch gekennzeichnet, dass** das Zink in der Zink enthaltenden Schicht in Form von elementarem Zink aufgebracht wird.

14. Das Verfahren nach einem der Ansprüche 11 bis 13, **dadurch gekennzeichnet, dass** auf das elektrisch nicht leitende Material mit einem PVD-Verfahren eine Schicht aus reinem elementaren Chrom aufgebracht wird.

15. Das Verfahren nach einem der Ansprüche 11 bis 14, **dadurch gekennzeichnet, dass** auf die PVD-Schicht enthaltend Chrom eine PVD-Schicht aus reinem elementaren Kupfer aufgebracht wird.

16. Das Verfahren nach einem der Ansprüche 11 bis 15, **dadurch gekennzeichnet, dass** die Schicht enthaltend Zink als Mischung oder Legierung mit anderen Metallen aufgebracht wird.

17. Das Verfahren nach einem der Ansprüche 11 bis 16, **dadurch gekennzeichnet, dass** die Schicht enthaltend Zink mit anderen Metallen und Dispersionen legiert oder gemischt ist.

18. Das Verfahren nach einem der Ansprüche 11 bis 17, **dadurch gekennzeichnet, dass** die weiteren Metalle oder Metallverbindungen ausgewählt sind aus der Gruppe Chrom, Eisen, Gold, Kobalt, Kupfer, Mangan, Nickel, Siliciumcarbid, Borcarbid, Aluminiumoxid oder Mischungen derselben.

19. Das Verfahren nach einem der Ansprüche 11 bis 18, **dadurch gekennzeichnet, dass** auf die Schicht enthaltend Zink weitere Schichten enthaltend Metall, vorzugsweise durch Galvanisieren aufgebracht werden.

20. Das Verfahren nach einem der Ansprüche 11 bis 19, **gekennzeichnet durch** die folgenden Schritte:
a) Aufbringen einer PVD-Schicht enthaltend Chrom auf ein elektrisch nicht leitendes Material, vorzugsweise auf ein Kunststoffmaterial,
b) Aufbringen einer PVD-Schicht enthaltend Kupfer auf die PVD-Schicht enthaltend Chrom,
c) Aufbringen einer Schicht enthaltend Zink auf die PVD-Schicht enthaltend Kupfer **durch** Galvanisieren, und
d) optional: Aufbringen weiterer metallhaltiger Schichten auf die Schicht enthaltend Zink, vorzugsweise **durch** Galvanisieren.

## Claims

1. An article, which at least in part has a surface made of an electrically non-conductive material, with an electrically conductive coating, **characterized in that** the electrically conductive coating has at least one electrodeposited zinc-containing layer, and at least one chromium-containing PVD layer is arranged between the electrically non-conductive material and the zinc-containing layer and at least one copper-containing PVD layer is arranged on said chromium-containing PVD layer.

2. The article according to claim 1, **characterized in that** the electrically non-conductive material is a plastic material.

3. The article according to claim 1 or 2, **characterized in that** the zinc in the zinc-containing layer is present in the form of elemental zinc.

4. The article according to any of claims 1 to 3, **characterized in that** the PVD layer coated on the electrically non-conductive material is a layer made of pure elemental chromium.

5. The article according to any of claims 1 to 4, **characterized in that** the chromium-containing PVD layer has a PVD layer of pure elemental copper coated thereon.

6. The article according to any of claims 1 to 5, **characterized in that** the zinc-containing layer contains additional elemental metals or metal compounds.

7. The article according to any of claims 1 to 6, **characterized in that** the zinc-containing layer is alloyed or mixed with other metals and dispersions.

8. The article according to any of claims 1 to 7, **characterized in that** the additional metals or metal compounds are selected from the group of chromium, iron, gold, cobalt, copper, manganese, nickel, silicon carbide, boron carbide, aluminum oxide or mixtures thereof.

9. The article according to any of claims 1 to 8, **characterized in that** the zinc-containing layer has additional layers containing elemental metal or metal compounds coated thereon.

10. The article according to any of claims 1 to 9, **characterized in that** the article, at least in the areas of the electrically non-conductive material, has the layer sequence:
a) electrically non-conductive material, preferably plastic material,
b) PVD layer containing chromium,
c) PVD layer containing copper,
d) layer containing zinc, and
e) optionally other metal-containing layers.

11. A method of coating electrically non-conductive materials, wherein at least one chromium-containing PVD layer is initially coated on said electrically non-conductive material, a copper-containing PVD layer is coated thereon, and an electrically conductive zinc-containing layer is electroplated on said copper-containing PVD layer.

12. The method according to claim 11, **characterized in that** as electrically non-conductive material, a plastic material is used as substrate for coating.

13. The method according to claim 11 or 12, **characterized in that** the zinc in the zinc-containing layer is coated in the form of elemental zinc.

14. The method according to any of claims 11 to 13, **characterized in that** a layer made of pure elemental chromium is coated on the electrically non-conductive material, using a PVD process.

15. The method according to any of claims 11 to 14, **characterized in that** a PVD layer of pure elemental copper is coated on the chromium-containing PVD layer.

16. The method according to any of claims 11 to 15, **characterized in that** the zinc-containing layer is coated in the form of a mixture or alloy with other metals.

17. The method according to any of claims 11 to 16, **characterized in that** the zinc-containing layer is alloyed or mixed with other metals and dispersions.

18. The method according to any of claims 11 to 17, **characterized in that** the additional metals or metal compounds are selected from the group of chromium, iron, gold, cobalt, copper, manganese, nickel, silicon carbide, boron carbide, aluminum oxide or mixtures thereof.

19. The method according to any of claims 11 to 18, **characterized in that** additional layers containing metal are coated on the zinc-containing layer, preferably by electroplating.

20. The method according to any of claims 11 to 19, **characterized by** the following steps:
a) coating a chromium-containing PVD layer on an electrically non-conductive material, preferably a plastic material,
b) coating a copper-containing PVD layer on said chromium-containing PVD layer,
c) coating a zinc-containing layer on said copper-containing PVD layer using electroplating, and
d) optionally, coating additional metal-containing layers on said zinc-containing layer, preferably by means of electroplating.

## Revendications

1. Objet, qui présente au moins en partie une surface composée d'un matériau électriquement non conducteur avec un revêtement électriquement conducteur,
**caractérisé en ce que**
le revêtement électriquement conducteur présente au moins une couche contenant du zinc appliquée par galvanisation et, entre le matériau électriquement non conducteur et la couche contenant du zinc, au moins une couche PVD (à dépôt physique en phase gazeuse) contenant du chrome, et sur celle-ci, au moins une couche PVD contenant du cuivre.

2. Objet selon la revendication 1,
**caractérisé en ce que**
le matériau électriquement non conducteur est un matériau en matière plastique.

3. Objet selon la revendication 1 ou 2,
**caractérisé en ce que**
le zinc dans la couche contenant du zinc est sous la forme de zinc élémentaire.

4. Objet selon l'une des revendications 1 à 3,
**caractérisé en ce que**
la couche PVD appliquée sur le matériau électriquement non conducteur est une couche composée de chrome élémentaire pur.

5. Objet selon l'une des revendications 1 à 4,
**caractérisé en ce que**
sur la couche PVD contenant du chrome, est appliquée une couche PVD composée de cuivre élémentaire pur.

6. Objet selon l'une des revendications 1 à 7,
**caractérisé en ce que**
la couche contenant du zinc contient d'autres métaux élémentaires ou des composés métalliques.

7. Objet selon l'une des revendications 1 à 6,
**caractérisé en ce que**
la couche contenant du zinc est alliée ou mélangée avec d'autres métaux et dispersions.

8. Objet selon l'une des revendications 1 à 7,
**caractérisé en ce que**
les autres métaux ou composés métalliques sont choisis dans le groupe comprenant le chrome, le fer, de l'or, le cobalt, le cuivre, le manganèse, le nickel, le carbure de silicium, le carbure de bore, l'oxyde d'aluminium ou des mélanges de ceux-ci.

9. Objet selon l'une des revendications 1 à 8,
**caractérisé en ce que**
sur la couche contenant du zinc, d'autres couches contenant un métal élémentaire ou des composés métalliques sont appliquées.

10. Objet selon l'une des revendications 1 à 9,
**caractérisé en ce que**
l'objet présente au moins aux endroits du matériau électriquement non conducteur la suite de couches :
a) un matériau électriquement non conducteur, de préférence un matériau en matière plastique,
b) une couche PVD contenant du chrome,
c) une couche PVD contenant du cuivre,
d) une couche contenant du zinc, et
e) en option, d'autres couches métallifères.

11. Procédé de revêtement de matériaux électriquement non conducteurs, selon lequel, sur le matériau électriquement non conducteur, on applique d'abord au moins une couche PVD contenant du chrome, puis on applique sur celle-ci une couche PVD contenant du cuivre, et sur celle-ci on applique par galvanisation une couche électriquement conductrice contenant du zinc.

12. Procédé selon la revendication 11,
**caractérisé en ce que**
le matériau électriquement non conducteur utilisé est un matériau en matière plastique servant de substrat pour le revêtement.

13. Procédé selon la revendication 11 ou 12,
**caractérisé en ce que**
le zinc dans la couche contenant du zinc est appliqué sous la forme de zinc élémentaire.

14. Procédé selon l'une des revendications 11 à 13,
**caractérisé en ce qu'**
une couche composée en chrome élémentaire pur est appliquée sur le matériau électriquement non conducteur au moyen d'un procédé PVD.

15. Procédé selon l'une des revendications 11 à 14,
**caractérisé en ce que**
sur la couche PVD contenant du chrome, est appliquée une couche PVD en cuivre élémentaire pur.

16. Procédé selon l'une des revendications 11 à 15,
**caractérisé en ce que**
la couche contenant du zinc est appliquée comme mélange ou alliage avec d'autres métaux.

17. Procédé selon l'une des revendications 11 à 16,
**caractérisé en ce que**
la couche contenant du zinc est alliée ou mélangée avec d'autres métaux et dispersions.

18. Procédé selon l'une des revendications 11 à 17,
**caractérisé en ce que**
les autres métaux ou composés métalliques sont choisis dans le groupe comprenant le chrome, le fer, l'or, le cobalt, le cuivre, le manganèse, le nickel, le carbure de silicium, le carbure de bore, l'oxyde d'aluminium ou des mélanges de ceux-ci.

19. Procédé selon l'une des revendications 11 à 18,
**caractérisé en ce que**
sur la couche contenant du zinc, d'autres couches contenant un métal sont appliquées, de préférence par galvanisation.

20. Procédé selon l'une des revendications 11 à 19,
**caractérisé par** les étapes suivantes :
a) application d'une couche PVD contenant du chrome sur un matériau électriquement non conducteur, de préférence un matériau en matière plastique,
b) application d'une couche PVD contenant du cuivre sur la couche PVD contenant du chrome,
c) application par galvanisation d'une couche contenant du zinc sur la couche PVD contenant du cuivre, et
d) en option : application d'autres couches métallifères sur la couche contenant du zinc, de préférence par galvanisation.
